# EUROPEAN PATENT SPECIFICATION

(11) **EP 1 815 295 B1**
(45) Date of publication and mention of the grant of the patent: **03.12.2008**
(21) Application number: 05805199.6
(22) Date of filing: 03.11.2005
(51) Int. Cl.: G03F 7/20, G02B 26/00

(54) **ARRAY OF SPATIAL LIGHT MODULATORS AND METHOD OF PRODUCTION OF A SPATIAL LIGHT MODULATOR DEVICE**
ARRAY VON RÄUMLICHEN LICHTMODULATOREN UND VERFAHREN ZUR HERSTELLUNG EINER RÄUMLICHEN LICHTMODULATIONSVORRICHTUNG
RESEAU DE MODULATEURS SPATIAUX DE LUMIERE ET PROCEDE DE PRODUCTION D'UN DISPOSITIF A MODULATEURS SPATIAUX DE LUMIERE

(30) Priority: 09.11.2004 EP 04105607
(43) Date of publication of application: 08.08.2007
(73) Proprietor: Koninklijke Philips Electronics N.V., 5621 BA Eindhoven (NL)
(72) Inventor: DE SAMBER, Marc, A., NL-5656 AA Eindhoven (NL); DE JONG, Michiel, NL-5656 AA Eindhoven (NL); NELLISSEN, Antonius, J., M., NL-5656 AA Eindhoven (NL); VAN VEEN, Nicolaas, J., A., NL-5656 AA Eindhoven (NL)
(74) Representative: Schouten, Marcus Maria
(86) International application number: PCT/IB2005/053588
(87) International publication number: WO 2006/051448

(56) References cited:
- EP-A1- 1 369 730
- EP-A2- 1 162 169
- EP-A2- 1 280 007
- US-A1- 2004 130 561
- ADRIAN MICHALICEK M ET AL: "Flip-chip fabrication of advanced micromirror arrays" SENSORS AND ACTUATORS A, ELSEVIER SEQUOIA S.A., LAUSANNE, CH, vol. 95, no. 2-3, 1 January 2002 (2002-01-01), pages 152-167, XP004377887 ISSN: 0924-4247

## Description

The invention relates to an array of spatial light modulators and a method of production of a spatial light modulator device. More specifically, it relates to arrays of spatial light modulators as can be used in maskless lithography systems

For the production of semiconductor devices, lithographic technologies are used. The most common approaches are based on the step-principle or on the step-and-scan-principle. Both approaches are working with masks providing the structure to be projected onto a substrate. The masks have to show a high degree of accuracy and are very expensive.

To avoid such high costs, especially for testing and producing only small numbers of semiconductor devices of one structure, so-called maskless lithography has been developed. Instead of masks, programmable spatial light modulators (SLMs) are used. This technology is explained in detail in US 6,312,134 B1. Possible SLMs are for example deformable micro-mirror devices for working in the reflection mode or liquid crystal light valves for working in the transmission mode.

A SLM comprises a multitude of units like deformable mirror-devices or liquid crystal light valves, each corresponding to a pixel of the structure to be illuminated. Every pixel can be switched between the two states, i.e. illuminating or not illuminating the corresponding point on the wafer surface. Some SLMs have units with also an intermediate state, illuminating the corresponding point on the substrate surface with an intermediate intensity.

The digitalized structure to be projected is provided by a control unit, that controls every pixel and can switch the corresponding unit into the necessary state. If the structure to be projected is changed, the states of the units of the SLM are changed, too, where necessary.

For larger structures or multiple simultaneous projection of a structure on a substrate, a plurality of SLMs have to be arranged in a planar configuration with very tight specifications in terms of x- and y-position and planarity.

The known approach for meeting these specifications is based on using sophisticated combinations of transducers and multiple stages.

The document EP 1 162 169 A2 describes methods for interconnecting microelectronic machined mechanical systems (MEMS). The substrate of choice for a MEMS device is typically a semi-conductor wafer e.g. silicon. A micro-mechanical mirror array is produced according to this document by mounting an array of MEMS devices on a silicon substrate. A silicon chamber can be provided to enclose the MEMS devices. The individual wafers are therefore prepared with large openings to accommodate the MEMS devices.

The document US 2004/0130561 discloses a mask-less lithography system with multiplexed spatial light modulators. The spatial light modulators are arranged in twin planes on a substrate, such that the chip kerf and connector fan-in regions overlap substantially.

The document EP 1 369 730 A1 describes flip-chip fabrication of a micromirror unit which has a mirror substrate and a wiring substrate that is spaced by conductive spacers.

The document of Michalicek and Bright disclosed in Sensors and Actuators A 95 (2002), pages 152-167, entitled "Flip-chip fabrication of advanced micromirror arrays" describes the design, fabrication, modeling and testing of advanced micromirror arrays that are created by use of a flip-chip assembly technique. The arrays are assembled by flip-chip bonding the upper structural layers of a micromirror array host chip to the lower structural layers of a receiving sub-mount chip using a custom built flip-chip bonding machine.

The document EP 1 280 007 describes an imaging apparatus that comprises a support structure for supporting patterning means. The patterning means serve to pattern the projection beam generated by a radiation system according to a desired pattern. A patterning means comprises a plurality of separate patterning sub-elements. Each sub-element is used to generate a patterned sub-beam. The apparatus furthermore comprises combining means for combining the plurality of patterned sub-beams into a single patterned image.

It is an object of the present invention to provide an easy to handle array of SLMs that is easy to produce.

In a first aspect of the present invention, there is provided a method according to claim 1 for the production of a SLM device, comprising the step of mounting a spatial light modulator on a substrate of the same material as the main material of the SLM array to be juxtaposed with the substrate. Particularly, silicon based SLMs are mounted on a silicon substrate.

A SLM device may comprise a single or a plurality of SLMs, leading to an array of SLMs. The present invention is independent of the number of SLMs used and works as well for a single SLM array as for a plurality of SLMs.

The special choice of the substrate material leads to a perfect thermal match of substrate and SLM. This is a very important step in achieving the severe specifications with respect to position and planarity for use in a maskless lithography system. During illumination of the SLM device, impinging photons deposit energy in the SLM device inducing a substantial thermal load. Different coefficients of thermal expansion of the substrate and the SLMs would lead to major deformations of the SLM device, thus making it eventually impossible to reach the specifications. By selecting the substrate material to match the material of the SLMs, specifically the main material to be juxtaposed with the substrate, e.g. a carrier substrate of the SLM itself, both substrate and SLM behave in the same way, when heated, such that only a scale effect with respect to x- and y-positions has to be taken into account during illumination, but no deformations.

In preferred embodiments of the present invention, the SLM is mounted by using surface mount technology, preferably by soldering. This has the advantage, especially if using a solder with high surface tension, that the self-aligning effect of solder during reflow due to minimizing the surface energy of the solder provides SLM devices of low variation with respect to position and planarity. This helps meeting the severe specifications and lowers production cost.

In preferred embodiments of the present invention, the substrate is preformed to provide it with an opening for exposing the SLM. Preferably, only one side of the substrate is provided with the infrastructure for the SLM such as electronic circuits, connectors etc.. The other side can be processed to be optimized for optical use like having a defined reflection or absorption characteristic.

Both measures are especially useful, when arranging the SLM in a flip-chip geometry. Then, the optically active side of the SLM is oriented such that it is exposed to the light, when being illuminated, as well as the side of the substrate optimized for optical use, while all the infrastructure is on the other side of the substrate. This has the advantage, that the infrastructure is not endangered by the light, particularly when using deep ultra-violet light, and that the infrastructure does not impede a correct illumination e.g. by generating stray light.

In a further aspect of the present invention, an array of SLMs on a substrate is provided, wherein the substrate is of the same material as the main material of the SLMs to be juxtaposed with the substrate. The SLMs may be mounted on the substrate by means of solder-defined self-aligning connections and are arranged in flip-chip geometry, the substrate having openings for exposing the SLMs, the infrastructure for the SLMs being provided on one side of the substrate, while the other side has a defined reflection or absorption function.

In a last aspect to the present invention, a maskless lithography system with such an array of SLMs is provided.

A detailed description of the invention is provided below. Said description is provided by way of a non-limiting example to be read with reference to the attached drawings in which:
Fig. 1 shows an embodiment of the production method according to the invention;
Figs. 2a,b show a solder connection before and after reflow;
Fig. 3 shows a SLM mounted on a substrate;
Fig. 4 shows the light side of an array of SLMs;
Fig. 5 shows the dark side of an array of SLMs;
Fig. 6 Shows a basic sketch of a maskless lithography system;
Fig. 7 shows the light side of a regular array of SLMs.

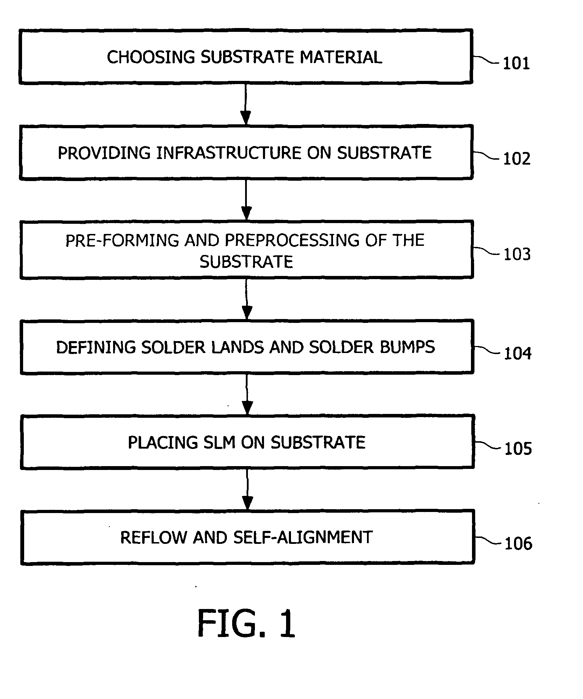

Figure 1 shows an embodiment of the production method according to the invention. In a first step 101, one has to choose the appropriate material for the substrate depending on the SLM to be mounted on the substrate. Most SLMs are semiconductor devices, i.e. the SLM is arranged on a carrier substrate. This carrier substrate is the part of the SLM that will actually be juxtaposed with the substrate. Therefore, the substrate material is to be chosen to be the same as the material of the carrier substrate to get a perfect thermal match.

It will be noted, that the described method works not only for a single SLM, but also for two, three, or a plurality of SLMs.

Once the substrate material is chosen, in a next step 102, the side of the substrate opposite to the light side (so-called dark side) is provided with all the necessary infrastructure for the SLM, e.g. flex connections, preamplifiers, electrical circuitry, thin film interconnects, connection pads, microconnectors etc.. Some components have to be quite near to the SLM like preamplifiers, whereas other components can be farther away and connected with the SLM by thin film interconnects and/or flex connectors.

Following the pre-forming and preprocessing of the substrate, the substrate is pre-formed (step 103) to provide it with an opening corresponding to the size of the optically active surface of the SLM to be used, and preprocessed to provide one side of the substrate (so-called light side) with a finishing layer for providing defined absorption or reflection characteristics. Preferably, the finishing layer is an anti-reflection layer, such as for example a chromium oxide layer as is used on photomasks. Another advantageous possibility is to use a UV light absorbing layer, especially an absorbing polymer layer as is used in integrated circuit fabrication processes.

Then, the actual mounting of the SLM on the substrate can take place. In step 104, the solder lands are accurately defined and the solder bumps carefully controlled, before placing substrate and SLM accurately together in step 105. The solder lands or solderable interconnect pads are defined on both the substrate and the carrier substrate of the SLM, whereas the solder bumps are placed only on the solder lands of either the substrate or the SLM. Solder lands are accurately defined by etching windows in e.g. a silicon nitride passivation layer on the substrate, using photolithography and reactive ion etching. Preferably, a solder with high surface tension is used. Very much preferred are solders, which have a high tin content.

The last step 106 is the reflow leading to self-alignment of the SLM with respect to the substrate. One possible reflow process could be the following: First, the SLM device is preheated to gradually heat it up. The device is then kept at a temperature near to the temperature at which solder bonding can occur till all parts of the SLM device have reached the same temperature. The actual reflow is, when the device is heated to a temperature above the melting point of the solder for bonding. Afterwards, the SLM device is cooled evenly to avoid thermal shock. The reflow process may occur in an inert or eventually reducing atmosphere, in order to prevent oxidation of the solder bumps, which in turn would hamper the self-aligning process.

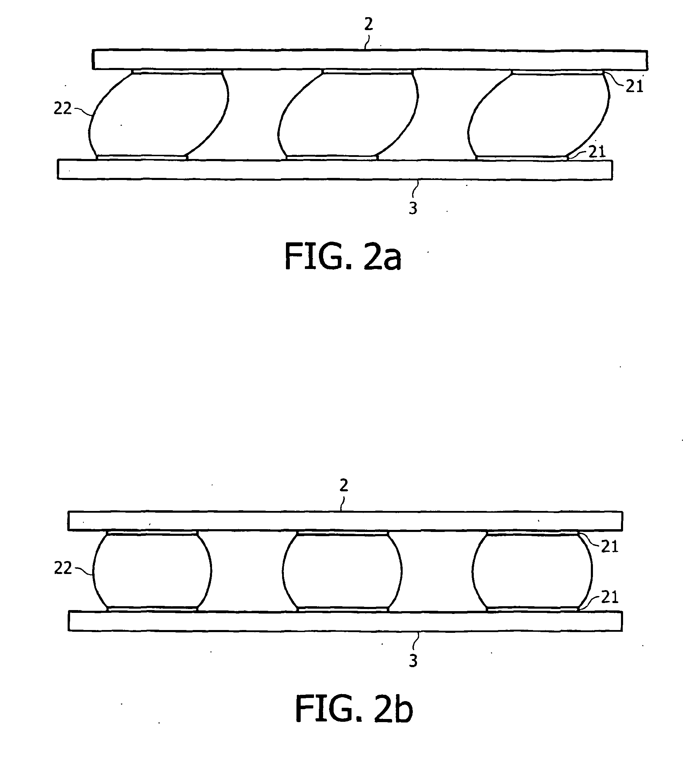

The self-alignment during reflow is illustrated in more detail in Figures 2a and 2b. Figures 2a and 2b show a SLM 2 and a substrate 3. Both SLM 2 and substrate 3 are provided with solder lands 21 and are in contact via solder bumps 22. In Figure 2a is shown the state before reflow, in which SLM 2 and substrate 3 are poorly aligned. In the reflow process, when the solder bumps 22 become liquid, due to minimization of free energy, the free surface of the solder bumps 22 is minimized. This leads to accurate alignment of the substrate 3 and the SLM 2. The alignment is not only reached for the displacement in the XY-plane, but also for the rotation in the XY-plane and the out-of-plane rotation.

Calculated examples show that submicron accuracy, especially a x- and y-position accuracy equal or better than 0,5 µm, can be achieved, when using a fair number of bumps. It has been derived that the expectation value of accuracy scales with the number of bumps used. For example, a 40 mm square chip with 1600 IOs has two rows of solder lands and bumps at pitch of 200 µm. The solder land diameter is 100 µm. The nominal stand-off is 80 µm with an individual spread in the order of several micrometers. In order to have a resulting angle less than 7 µrad, the variation in bump height should be less than 2 µm. It allows for a 3% variation in deposited solder volume per bump.

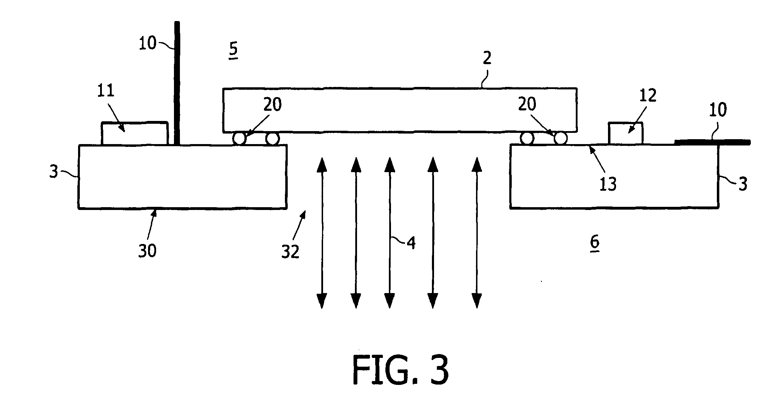

Figure 3 shows a SLM 2 on silicon basis mounted onto a silicon substrate 3. The SLM 2 is arranged in flip-chip geometry on the substrate 3, such that the optically active side of the SLM 2 is exposed to the illuminating light beam 4 through the opening 32. The side 6 of the substrate 3 that is exposed to the light 4 is the light side 6. A finishing layer 30 has been deposited on the light side 6 of the substrate 3 to provide defined absorption or reflection characteristics. On the opposite side 5 of the substrate 3, the dark side 5, the SLM 2 is fixed to the substrate 3 by solder connections 20. The SLM shown in Figure 3 is used in reflection mode and is based on micro-mirror devices.

The infrastructure for the SLM 2 is provided on the dark side 5, e.g. a preamplifier 11, flex connections 10, that can be oriented in any direction, fine pitch thin film interconnects 13 and electrical circuitry 12. Dividing the SLM device into a light side 6 and a dark side 5 has two major advantages: The infrastructure is protected from the illuminating light 4, and the infrastructure does not impede the imaging process, as it is hidden.

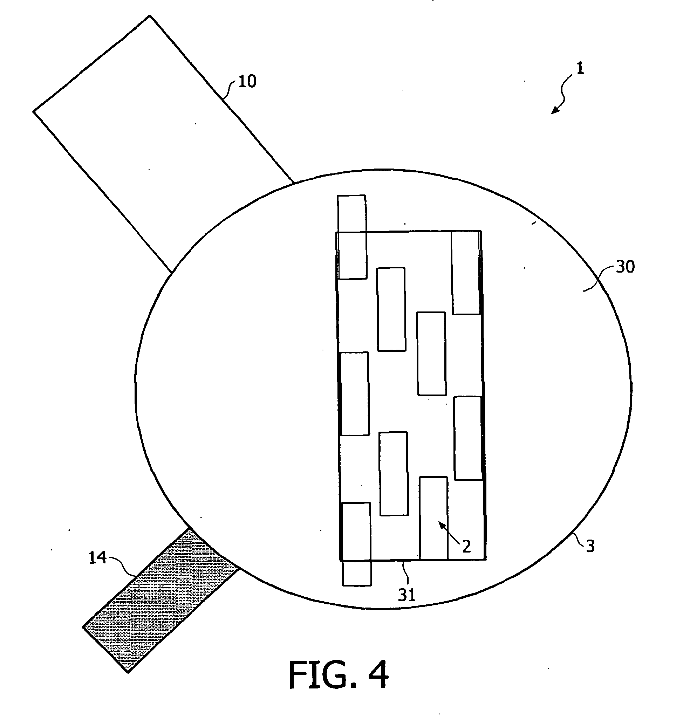

Figure 4 shows the light side of an array I of SLMs 2. The SLMs 2 are arranged in an optically active area 31 of the substrate 3, that is actually to be illuminated. The substrate 3 has an antireflection or absorbing finishing layer 30 to make sure, that any structure to be projected on e.g. a wafer is due only to the SLMs 2 and not to any stray reflects of the substrate. The normal flex connection 10 and the micro-fine pitch connection 14 are the only parts of the infrastructure from the dark side of the substrate 3 that are visible, but very far away from the optically active area 31.

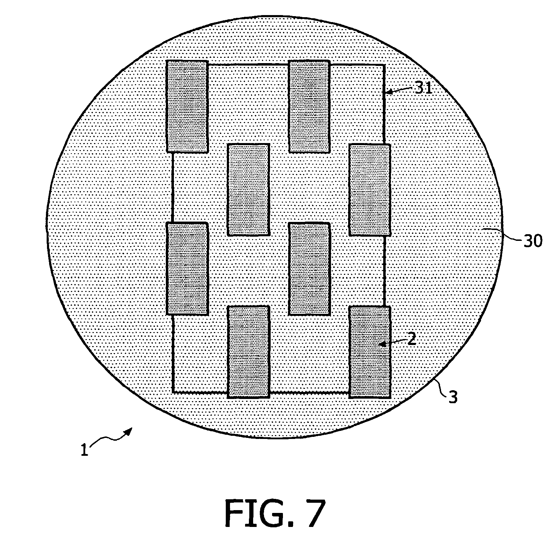

One will notice, that the SLMs 2 of the optically active area 31 are arranged in an irregular manner in Figure 4. The invention is applicable to any arrangement of SLMs, e.g. to a regular arrays 1 as illustrated in Figure 7.

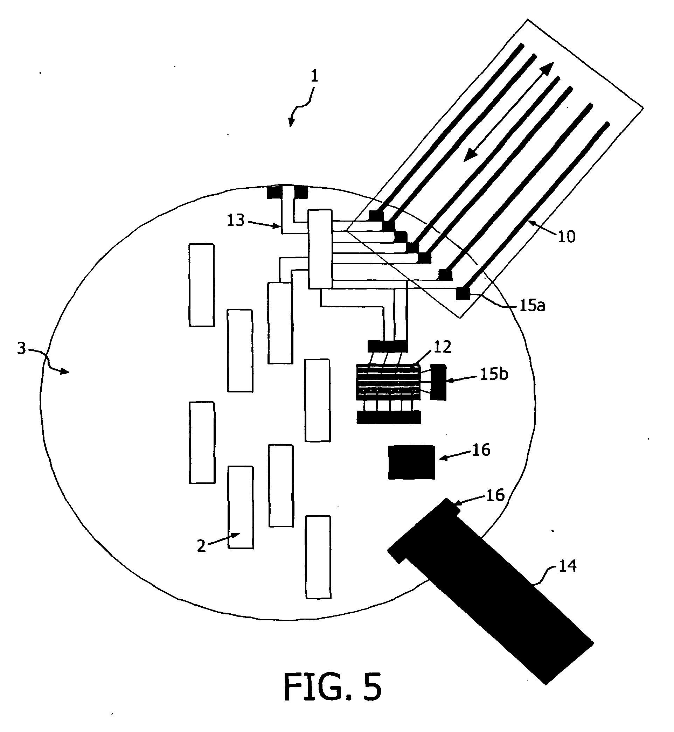

Figure 5 shows the dark side of an array 1 of SLMs 2. Besides the SLMs 2, diverse components operating as infrastructure for the SLMs 2 are mounted on the substrate 3. As example are shown a flex connection 10 connecting the SLMs 2 via fine pitch thin film interconnects 13 and pads 15a with a control unit, e.g. a computer, where the structure data to be implemented by the SLMs 2 is provided, circuitry 12 connected via connecting pads 15b, and micro-connectors 16, e.g. for connecting micro-fine pitch connections 14.

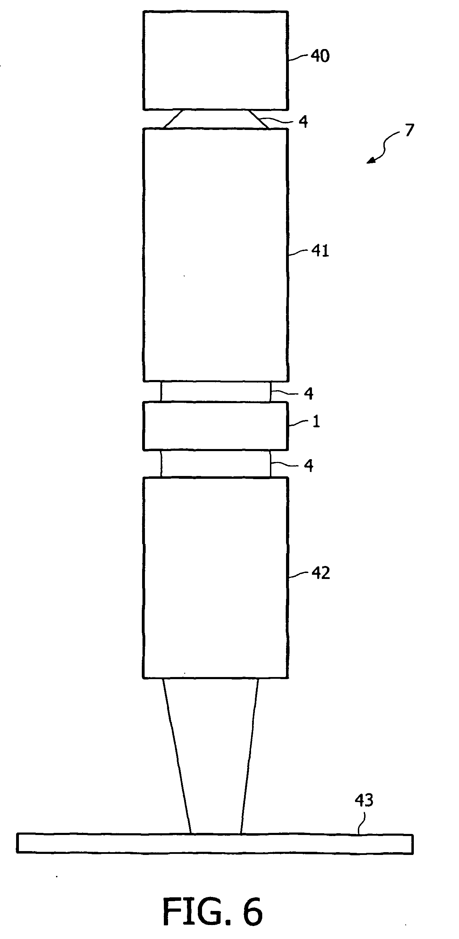

Figure 6 sketches a basic maskless lithography system 7. Light 4 is emitted by a light source 40. The illuminating system optimizes the light 4 for illumination of the array 1 of SLMs. In the present example, the array 1 is used in transmission with SLMs based on liquid crystal light valve devices. The light 4 transmitted by the array 1 of SLMs is projected on the wafer 43 for imaging with the help of a projection system 42.

Although having described several preferred embodiments of the invention, those skilled in the art would appreciate that various changes, alterations, and substitutions can be made without departing from the scope of the present invention. The invention is, therefore, claimed in any of its forms or modifications with the proper scope of the appended claims. For example various combinations of the features of the following dependent claims could be made with the features of the independent claim without departing from the scope of the present invention. Furthermore, any reference numerals in the claims shall not be construed as limiting scope.

### LIST OF REFERENCE NUMERALS:

- 1: array of SLMs
- 2: SLM
- 3: substrate
- 4: light
- 5: dark side
- 6: light side
- 7: maskless lithography system
- 10: flex connection
- 11: preamplifier
- 12: electrical circuitry
- 13: thin film interconnect
- 14: micro-fine pitch connection
- 15a,b: pad
- 16: microconnector
- 20: solder connection
- 21: solder land
- 22: solder bump
- 30: finishing layer
- 31: optically active area
- 32: opening
- 40: light source
- 41: illumination system
- 42: projection system
- 43: wafer

## Claims

1. A method for the production of a spatial light modulator device comprising the step of mounting a spatial light modulator (2) on a substrate (3) of the same material as the main material of the spatial light modulator to be juxtaposed with the substrate, **characterized in that** the substrate has an opening (32) for exposing the spatial light modulator and that the spatial light modulator is arranged in a flip-chip geometry on the substrate.

2. The method according to claim 1, wherein a silicon-based spatial light modulator is being mounted on a silicon substrate.

3. The method according to claim 1 or 2, comprising the further step of mounting the spatial light modulator on the substrate by using surface mount technology.

4. The method according to claim 1, 2 or 3, comprising the further step of mounting the spatial light modulator on the substrate by soldering.

5. The method according to any of claims 1 to 4, comprising the further step of mounting the spatial light modulator on the substrate by defming solder lands and solder bumps, putting the spatial light modulator and the substrate together, and making use of the effect of minimization of free surface of the solder bumps during reflow for self alignment of the spatial light modulator with respect to the substrate.

6. The method according to claim 3, 4 or 5 wherein a solder with high surface tension is used.

7. The method according to any of claims 3 to 6, wherein a solder with a high tin content is used.

8. The method according to any of claims 1 to 7, comprising the further step of pre-forming the substrate to provide the substrate with an opening for exposing the spatial light modulator.

9. The method according to any of claims 1 to 8, comprising the further step of providing the infrastructure for the spatial light modulator on only one side of the substrate.

10. The method according to any of claims 1 to 9, comprising the further step of processing the other side of the substrate to attain a defined reflection or absorption.

11. An array (1) of spatial light modulators (2) on a substrate (3), wherein the substrate (3) is of the same material as the main material of the spatial light modulators (2) to be juxtaposed with the substrate (3), **characterized in that** the substrate (3) has openings (32) for exposing the spatial light modulators and that the spatial light modulators (2) are arranged in flip-chip geometry.

12. The array according to claim 11, wherein the spatial light modulators (2) are mounted on the substrate (3) by means of solder-defined self-aligning connections (20).

13. The array according to claim 11 or 12, wherein the infrastructure (10, 11, 12, 13, 14, 15a,b, 16) for spatial light modulator (2) is provided on one side (5) of the substrate (3), while the other side (6) has a defined reflection or absorption function.

14. A maskless lithography system (7) with an array (1) of spatial light modulators (2) according to claim 11, 12 or 13.

## Patentansprüche

1. Verfahren zur Herstellung einer räumlichen Lichtmodulatoreinrichtung, welches den Schritt des Anbringens eines räumlichen Lichtmodulators (2) auf einem Substrat (3) aus dem gleichen Material wie das Hauptmaterial des dem Substrat gegenüberzustellenden, räumlichen Modulators umfasst, **dadurch gekennzeichnet, dass** das Substrat eine Öffnung (32) aufweist, um den räumlichen Lichtmodulator zu exponieren, und dass der räumliche Lichtmodulator auf dem Substrat in einer Flip-Chip-Geometrie angeordnet ist.

2. Verfahren nach Anspruch 1, wobei ein räumlicher Lichtmodulator auf Siliciumbasis auf einem Siliciumsubstrat angebracht wird.

3. Verfahren nach Anspruch 1 oder 2, welches den weiteren Schritt des Anbringens des räumlichen Lichtmodulators auf dem Substrat unter Anwendung der Oberflächenmontagetechnik umfasst.

4. Verfahren nach Anspruch 1, 2 oder 3, welches den weiteren Schritt des Anbringens des räumlichen Lichtmodulators auf dem Substrat durch Löten umfasst.

5. Verfahren nach einem der Ansprüche 1 bis 4, welches den weiteren Schritt des Anbringens des räumlichen Lichtmodulators auf dem Substrat durch Definieren von Kontaktflächen und Lötkontakthügeln umfasst, wobei der räumliche Lichtmodulator und das Substrat aneinander gefügt werden und von dem Effekt der Minimierung der freien Oberfläche der Lötkontakthügel bei Reflow zur Selbstjustage des räumlichen Lichtmodulators gegenüber dem Substrat Gebrauch gemacht wird.

6. Verfahren nach Anspruch 3, 4 oder 5, wobei ein Lötmittel mit hoher Oberflächenspannung verwendet wird.

7. Verfahren nach einem der Ansprüche 3 bis 6, wobei ein Lötmittel mit einem hohen Zinngehalt verwendet wird.

8. Verfahren nach einem der Ansprüche 1 bis 7, welches den weiteren Schritt des Vorformens des Substrats umfasst, um das Substrat zum Exponieren des räumlichen Lichtmodulators mit einer Öffnung zu versehen.

9. Verfahren nach einem der Ansprüche 1 bis 8, welches den weiteren Schritt des Vorsehens der Infrastruktur für den räumlichen Lichtmodulator auf nur einer Seite des Substrats umfasst.

10. Verfahren nach einem der Ansprüche 1 bis 9, welches den weiteren Schritt des Bearbeitens der anderen Seite des Substrats umfasst, um eine definierte Reflexion oder Absorption zu erreichen.

11. Array (1) von räumlichen Lichtmodulatoren (2) auf einem Substrat (3), wobei das Substrat (3) aus dem gleichen Material wie das Hauptmaterial der dem Substrat (3) gegenüberzustellenden, räumlichen Lichtmodulatoren (2) besteht, **dadurch gekennzeichnet, dass** das Substrat (3) Öffnungen (32) aufweist, um die räumlichen Lichtmodulatoren zu exponieren, und dass die räumlichen Lichtmodulatoren (2) in Flip-Chip-Geometrie angeordnet sind.

12. Array nach Anspruch 11, wobei die räumlichen Lichtmodulatoren (2) auf dem Substrat (3) mit Hilfe von durch Lötmittel definierten, selbstjustierenden Verbindungen (20) angebracht werden.

13. Array nach Anspruch 11 oder 12, wobei die Infrastruktur (10, 11, 12, 13, 14, 15a,b, 16) für den räumlichen Lichtmodulator (2) auf einer Seite (5) des Substrats (3) vorgesehen ist, während die andere Seite (6) eine definierte Reflexions- oder Absorptionsfunktion aufweist.

14. Maskenloses Lithographiesystem (7) mit einem Array (1) von räumlichen Lichtmodulatoren (2) nach Anspruch 11, 12 oder 13.

## Revendications

1. Procédé de production d'un dispositif de modulateur spatial de lumière comprenant l'étape consistant à monter un modulateur spatial de lumière (2) sur un substrat (3) qui se compose du même matériau que le matériau principal du modulateur spatial de lumière à juxtaposer avec le substrat, **caractérisé en ce que** le substrat présente une ouverture (32) pour exposer le modulateur spatial de lumière et **en ce que** le modulateur spatial de lumière est agencé dans une géométrie dite flip-chip sur le substrat.

2. Procédé selon la revendication 1, dans lequel le modulateur spatial de lumière à base de silicium est monté sur un substrat de silicium.

3. Procédé selon la revendication 1 ou 2, comprenant la nouvelle autre étape consistant à monter le modulateur spatial de lumière sur le substrat à l'aide de la technologie de montage en surface.

4. Procédé selon la revendication 1, 2 ou 3, comprenant la nouvelle autre étape consistant à monter le modulateur spatial de lumière sur le substrat par soudage.

5. Procédé selon l'une quelconque des revendications précédentes 1 à 4, comprenant la nouvelle autre étape consistant à monter le modulateur spatial de lumière sur le substrat en définissant des parties intermédiaires de soudage et des perles de soudure, en assemblant le modulateur spatial de lumière et en faisant usage de l'effet de minimisation de la surface libre des perles de soudure pendant le reflux pour l'alignement automatique du modulateur spatial de lumière par rapport au substrat.

6. Procédé selon la revendication 3, 4 ou 5, dans lequel une soudure à haute tension de surface est utilisée.

7. Procédé selon l'une quelconque des revendications précédentes 3 à 6, dans lequel une soudure à haute teneur en étain est utilisée.

8. Procédé selon l'une quelconque des revendications précédentes 1 à 7, comprenant la nouvelle autre étape consistant à préformer le substrat de manière à pourvoir le substrat d'une ouverture pour exposer le modulateur spatial de lumière.

9. Procédé selon l'une quelconque des revendications précédentes 1 à 8, comprenant la nouvelle autre étape consistant à fournir l'infrastructure pour le modulateur spatial de lumière d'un seul côté du substrat.

10. Procédé selon l'une quelconque des revendications précédentes 1 à 9, comprenant la nouvelle autre étape consistant à traiter l'autre côté du substrat de manière à atteindre une réflexion ou une absorption définie.

11. Réseau (1) de modulateurs spatiaux de lumière (2) sur un substrat (3), dans lequel le substrat (3) se compose du même matériau que le matériau principal des modulateurs spatiaux de lumière (2) à juxtaposer avec le substrat (3), **caractérisé en ce que** le substrat (3) présente des ouvertures (32) pour exposer les modulateurs spatiaux de lumière et **en ce que** les modulateurs spatiaux de lumière (2) sont agencés dans une géométrie dite flip-chip.

12. Réseau selon la revendication 11, dans lequel les modulateurs spatiaux de lumière (2) sont montés sur le substrat (3) au moyen de raccordements d'alignement automatique définis par soudure (20).

13. Réseau selon la revendication 11 ou 12, dans lequel l'infrastructure (10, 11, 12, 13, 14, 15a, b, 16) pour le modulateur spatial de lumière (2) est prévue d'un côté (5) du substrat (3) alors que l'autre côté (6) présente une fonction de réflexion ou d'absorption définie.

14. Système de gravure sans masque (7) avec un réseau (1) de modulateurs spatiaux de lumière selon la revendication 11, 12 ou 13.
